# EUROPÄISCHE PATENTSCHRIFT

(11) **EP 0 579 959 B1**
(45) Veröffentlichungstag und Bekanntmachung des Hinweises auf die Patenterteilung: **18.03.1998**
(21) Anmeldenummer: 93109839.6
(22) Anmeldetag: 21.06.1993
(51) Int. Cl.: G01R 19/04, F02P 17/00

(54) **Vorrichtung zum Erfassen eines Signales**
Signal detecting device
Dispositif pour la détection d'un signal

(30) Priorität: 18.07.1992 DE 4223713
(43) Veröffentlichungstag der Anmeldung: 26.01.1994
(73) Patentinhaber: ROBERT BOSCH GMBH, 70442 Stuttgart (DE)
(72) Erfinder: Gern, Christian, Dipl.-Ing., D-7314 Wernau (DE)

(56) Entgegenhaltungen:
- EP-A- 0 140 396
- EP-A- 0 216 161
- EP-A- 0 477 507
- EP-A- 0 540 878
- DE-A- 3 417 676
- US-A- 4 005 356
- US-A- 4 847 563
- EDN ELECTRICAL DESIGN NEWS, Bd.35, Nr.13, Juni 1990, NEWTON, MASSACHUSETTS US Seiten 217 - 228 J.KIRSTEN ET AL. 'Undersampling reduces data-acquisition costs for select applications'
- ELECTRONIC ENGINEERING, Bd.56, Nr.686, Februar 1984, LONDON GB Seiten 41 - 43 J.DRISCOLL 'Peak monitoring - improving digital storage scope performance'
- PT ELECTROTECHNIEK, ELEKTRONICA, Bd.43, Nr.8, August 1988, RIJSWIJK NL Seiten 24 - 27 'De 2440 draagbare digitale oscilloscoop'
- NEW ELECTRONICS, Bd.20, Nr.15, Juli 1987, LONDON GB Seite 12 D.WEDLAKE ET AL. 'Two-Stage Positive Peak Detector'
- EDN ELECTRICAL DESIGN NEWS, Bd.33, Nr.25/I, Dezember 1988, NEWTON, MASSACHUSETTS US Seite 300 N.C.GRAY 'Peak detector offers high bandwidth'

## Beschreibung

### Stand der Technik

Die Erfindung geht aus von einer Vorrichtung zum Erfassen eines Signals nach der Gattung des unabhängigen Anspruchs. Aus einem Beitrag in "New Electronics", Band 20, Nr. 15 (1987), Seite 12 ist eine Schaltung zum Erfassen von Spitzenwerten analoger Signale bekannt. Die Schaltung enthält eingangsseitig eine schnelle Abtast/Halte-Schaltung, wobei die Abtastung in Abhängigkeit von einem Vergleich des Ausgangssignals mit dem Eingangssignal der Abtast/Halte-Schaltung erfolgt. Der schnellen Abtast/Halte-Schaltung ist ein relativ langsamer Spitzenwertdetektor nachgeschaltet, der einen detektierten Spitzenwert für einen längeren Zeitraum zu speichern in der Lage ist als es die vorgeschaltete schnelle Abtast/Halte-Schaltung in der Lage wäre. Die endliche Signallaufzeit in der schnellen Abtast/Halte-Schaltung, die eine Signalverzögerung bewirkt, ermöglicht einen Vergleich des Ausgangs- mit dem Eingangssignal mittels eines schnellen Komparators.

Aus einer Veröffentlichung in der Zeitschrift "Electronic Engeneering", Band 56, Nr. 686 (1984), Seiten 41 bis 43 ist eine Eingangsschaltung eines Digital-Oszilloskops bekannt, die eine Erfassung von hochfrequenten Signalspitzen ermöglicht, obwohl der Analog/Digital-Converter relativ langsam ist. Vorgesehen ist ein Spitzenwertdetektor, dessen Ausgangssignal einer Abtast/Halte-Schaltung zugeführt wird. Eine Komparatorschaltung vergleicht die Eingangsspannung mit der Ausgangsspannung der Abtast/Halte-Schaltung. Aufgrund der endlichen Signalverarbeitungsgeschwindigkeit tritt bei einer zeitlichen Änderung des Eingangssignals eine Differenz auf, die zum Auslösen der Haltefunktion herangezogen wird.

Aus Unterlagen der Fa. Tektronix, 96453-EMS-598-10.91ps, "ScopeStation, Digital-Oszilloskope, Serie TDS 400" Oktober 1991 sind Digital-Speicheroszilloskope bekannt, die in einer vorgebbaren Betriebsart (High resolution-modus) den Mittelwert des innerhalb eines Intervalls liegenden erfaßten Signals bilden, der anschließend an der dem Intervall zugeordneten Stelle auf der Anzeigevorrichtung ausgegeben wird. In dieser Betriebsart werden von einem Analog/Digital-Wandler mehrere Werte des im Intervall liegenden Signals abgetastet, damit ein Mittelwert gebildet werden kann. Die Mittelwertbildung reduziert das hochfrequente Rauschen. In einer anderen Betriebsart (peak detect) arbeitet der Analog/Digital-Wandler stets mit der maximal möglichen Abtastrate. In dieser Betriebsart werden, unabhängig von der vorgegebenen Ablenkgeschwindigkeit, Spitzenwerte des zu verarbeitenden Signals durch Auswertung der digitalisierten Werte erfaßt und anstelle eines in dem vorgegebenen Intervall liegenden Abtastwertes auf der Anzeigevorrichtung dargestellt. Die maximale Abtastrate des Analog/Digital-Wandlers muß auf die erwartete höchste Frequenzkomponente des Spitzenwertes abgestimmt sein, damit das Abtasttheorem erfüllt wird.

Der Erfindung liegt die Aufgabe zugrunde, eine Vorrichtung zum Erfassen eines Signales anzugeben, bei der mit einfachen Mitteln Spitzenwerte eines Signals erfaßt und von einer Anordnung weiterverarbeitet werden können, deren Signalverarbeitungsgeschwindigkeit unterhalb derjenigen liegt, die für die Erfassung der Spitzenwerte erforderlich ist.

Die Aufgabe wird durch die im unabhängigen Anspruch angegebenen Merkmale gelöst.

### Vorteile der Erfindung

Die erfindungsgemäße Vorrichtung weist den Vorteil auf, daß ein innerhalb einer Abtastzeit liegendes positives oder negatives Maximum des erfaßten Signals zur weiteren Verarbeitung in einer Abtast/Halte-Schaltung solange festgehalten wird, bis ein erneuter Abtastvorgang der Abtast/Halte-Schaltung ausgelöst wird. Die Anforderungen an die Signalverarbeitungsgeschwindigkeit der nachfolgenden Signalverarbeitung sind erheblich niedriger als sie für die unmittelbare Erfassung von Spitzenwerten des Signals sein müßten. Vorgesehen sind Vergleichsmittel, die das Signal mit wenigstens einer vorgebbaren Schwelle vergleichen, wobei das Auslösen des Haltevorgangs der Abtast/Halte-Schaltung nur dann möglich ist, wenn ein Maximum erkannt ist und wenn gleichzeitig eine Schwellenüberschreitung vorliegt. Der besondere Vorteil dieser Maßnahme liegt darin, daß lokale Maxima des Signals, die unterhalb der vorgegebenen Schwelle liegen, bei der weiteren Signalverarbeitung nicht bevorzugt werden. Mit der Vorgabe von zwei unterschiedlichen Schwellen ist ein Amplitudenband vorgebbar, innerhalb dem die gezielte Erfassung von lokalen positiven oder negativen Maxima des Signals unterbindbar ist. Vorhanden sind weiterhin Signalverzögerungsmittel, die einer weiteren Abtast/Halte-Schaltung vorgeschaltet sind. Mit dieser Maßnahme werden definierte Verhältnisse geschaffen, die einen Vergleich des Ausgangssignals der weiteren Abtast/Halte-Schaltung mit deren Eingangssignal gestatten.

Eine besonders vorteilhafte Verwendung der erfindungsgemäßen Vorrichtung ist in einem digitalen Speicheroszilloskop gegeben. Das Speicheroszilloskop kann einen relativ langsamen Analog/Digital-Wandler enthalten und ermöglicht dennoch die Erfassung von Maxima des Eingangssignals, die Frequenzkomponenten aufweisen, die weit oberhalb der für den Analog/Digital-Wandler zulässigen Grenzfrequenz liegen. Die erfindungsgemäße Vorrichtung ermöglicht den Einsatz eines preisgünstigen, aber dennoch hochauflösenden Analog/Digital-Wandlers, ohne den Nachteil in Kauf nehmen zu müssen, daß Maxima des Eingangssignals nicht erfaßt werden.

Eine bevorzugte Verwendung findet die erfindungsgemäße Vorrichtung beim Erfassen von Zündsignalen, die bei einer Zündung von fremdgezündeten Brennkraftmaschinen auftreten. Besonders vorteilhaft wirkt sich bei dieser Anwendung die Möglichkeit aus, das erfaßte Maximum des Signals nur dann der weiteren Signalverarbeitung zuzuführen, sofern das Maximum größer als die vorgebbare Schwelle ist. Mit dieser Maßnahme werden Störsignale wirksam unterdrückt.

Weitere vorteilhafte Weiterbildungen und Ausgestaltungen der erfindungsgemäßen Vorrichtung ergeben sich aus der folgenden Beschreibung.

### Zeichnung

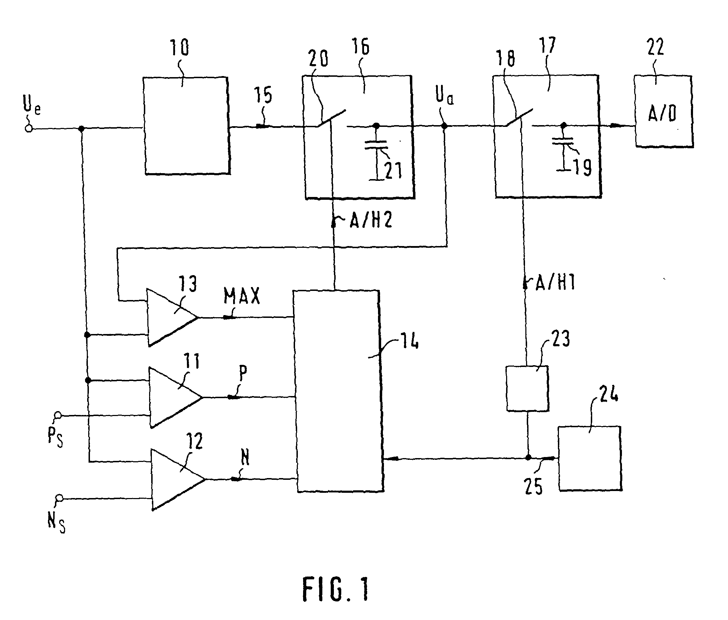

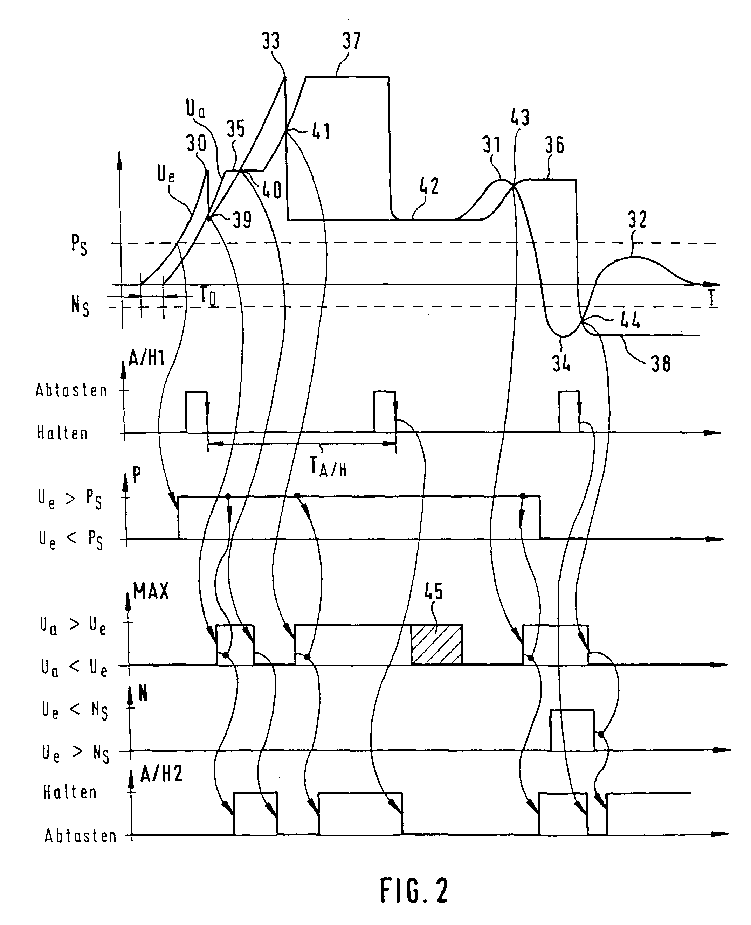

Figur 1 zeigt ein Blockschaltbild einer erfindungsgemäßen Vorrichtung zum Erfassen eines Signales, Figur 2 zeigt Signalverläufe in Abhängigkeit von der Zeit, die im Blockschaltbild gemäß Figur 1 auftreten.

In Figur 1 wird ein zu erfassendes Signal Uₑ Signalverzögerungsmitteln 10, ersten und zweiten Vergleichsmitteln 11, 12 sowie einem dritten Vergleichsmittel 13 zugeleitet. Das erste Vergleichsmittel 11 erhält einen positiven Schwellwert P_{S} und das zweite Vergleichsmittel 12 einen negativen Schwellwert N_{S} jeweils zugeführt. Das erste Vergleichsmittel 11 gibt ein Ausgangssignal P und das zweite Vergleichsmittel 12 ein Ausgangssignal N an eine signalverarbeitende Anordnung 14 ab.

Ein Ausgangssignal 15 der Signalverzögerungsmittel 10 wird einer Abtast/Halte-Schaltung 16 zugeleitet, die ein Ausgangssignal Uₐ an eine weitere Abtast/Halte-Schaltung 17 und an die dritten Vergleichsmittel 13 abgibt. Im folgenden werden die Abtast/Halte-Schaltung 17 als erste Schaltung und die Abtast/Halte-Schaltung 16 als zweite Schaltung bezeichnet. Die erste Abtast/Halte-Schaltung 17 enthält Schaltmittel 18 und einen Speicherkondensator 19. Das Schaltmittel 18 erhält ein Abtast/Halte-Signal A/H1 zugeleitet. Die zweite Abtast/Halte-Schaltung 16 enthält Schaltmittel 20 sowie einen Speicherkondensator 21. Das Schaltmittel 20 erhält ein Abtast/Halte-Signal A/H2 zugeleitet.

Die erste Abtast/Halte-Schaltung 17 gibt ein Signal an einen Analog/Digital-Wandler 22 ab.

Das Abtast/Halte-Signal A/H1 wird von einem Frequenzteiler 23 abgegeben, dem ein von einem Taktgenerator 24 abgegebenes Taktsignal 25 zugeführt wird. Das Taktsignal 25 ist weiterhin der signalverarbeitenden Anordnung 14 zugeleitet.

Das dritte Vergleichsmittel 13 gibt ein Ausgangssignal MAX an die signalverarbeitende Anordnung 14 ab.

Figur 2 zeigt Signalverläufe in Abhängigkeit von der Zeit T. Im oberen Teilbild sind das zu erfassende Signal Uₑ sowie das Ausgangssignal Uₐ der zweiten Abtast/Halte-Schaltung 16 gezeigt. Das Signal Uₐ weist gegenüber dem Signal Uₑ einen Zeitversatz T_{D} auf. Weiterhin sind im oberen Teilbild der positive Schwellwert P_{S} sowie der negative Schwellwert N_{S} strichliniert eingetragen. Das Signal Uₑ weist positive lokale Maxima 30, 31, 32, ein positives Maximum 33 sowie ein negatives Maximum 34 auf.

Das Signal Uₐ weist positive lokale Maxima 35, 36, ein positives Maximum 37 sowie ein negatives Maximum 38 auf.

Die beiden Signale Uₑ, Uₐ weisen Schnittpunkte und Berührungspunkte 39, 40, 41, 42, 43, 44 auf.

Das nächste Bild zeigt das Abtast/Halte-Signal A/H1. Eingetragen sind die Pegel, bei denen ein Abtast- und ein Haltevorgang der ersten Abtast/Halte-Schaltung 17 stattfindet. Hervorgehoben sind negative Schaltflanken des Signals A/H1, welche die Übernahme des Signals Uₐ in den Speicherkondensator 19 angeben. Zwischen zwei negativen Flanken liegt die Abtastzeit T_{A/H}, die die Abtastrate des Analog/Digital-Wandlers 22 festlegt.

Im nächsten Bild ist das Ausgangssignal P des ersten Vergleichsmittels 11 angegeben. Eingetragen ist der Pegel, bei dem das zu erfassende Signal Uₑ größer als der positive Schwellwert P_{S} und bei dem das Signal Uₑ kleiner als der positive Schwellwert P_{S} ist.

Im nächsten Bild ist das Ausgangssignal MAX des dritten Vergleichsmittels 13 angegeben. Eingetragen ist der Pegel, bei dem das Ausgangssignal Uₐ der zweiten Abtast/Halte-Schaltung 16 größer als das zu erfassende Signal Uₑ und bei dem das Ausgangssignal Uₐ kleiner als das Signal Uₑ ist. Das Signal MAX enthält einen Bereich 45, innerhalb dem der Pegel des Signal MAX von untergeordneter Bedeutung ist.

Im nächsten Bild ist das Ausgangssignal N des zweiten Vergleichsmittels 12 angegeben. Eingetragen ist der Pegel, bei dem das zu erfassende Signal Uₑ kleiner als der negative Schwellwert N_{S} und bei dem das Signal Uₑ größer als der negative Schwellwert N_{S} ist.

Im untersten Teilbild ist das Abtast/Halte-Signal A/H2 gezeigt, das von der signalverarbeitenden Anordnung 14 zur Steuerung des Schaltmittels 20 der zweiten Abtast/Halte-Schaltung 16 abgegeben wird. Eingetragen ist der Pegel, bei dem ein Halte- und ein Abtastvorgang stattfindet.

Die in Figur 1 gezeigte Vorrichtung wird anhand der in Figur 2 gezeigten Signalverläufe näher erläutert:

Das zu erfassende Signal Uₑ gelangt nach Durchlaufen der Signalverzögerungsmittel 10 in die zweite Abtast/Halte-Schaltung 16. Die Signalverzögerungsmittel 10 sind vorzugsweise als Allpaß-Schaltung realisiert. Die Verzögerungsmittel 10 legen den im oberen Bild von Figur 2 gezeigten Zeitversatz T_{D} zwischen den Signalen Uₑ, Uₐ fest, wenn von der Zeitverzögerung der zweiten Abtast/Halte-Schaltung 16 abgesehen wird. Beim Schnittpunkt 39 der beiden Signale Uₑ, Uₐ, bei dem das Signal Uₐ größer als das Signal Uₑ ist, tritt das Signal MAX auf, welches das Vorliegen zumindest eines lokalen Maximums 30 anzeigt. Daraufhin wird mit dem Abtast/Halte-Signal A/H2 ein Haltevorgang der zweiten Abtast/Halte-Schaltung 16 veranlaßt. Das Signal Uₐ weist danach das lokale Maximum 35 auf, das dem Maximum 33 des Signals Uₑ entspricht. Gemäß einer ersten bevorzugten Ausgestaltung wird der Haltevorgang mit dem Abtast/Halte-Signal A/H2 jedoch nur dann veranlaßt, wenn gleichzeitig das Signal P vorliegt, welches anzeigt, daß das zu erfassende Signal Uₑ größer als der positive Schwellwert P_{S} ist. Mit dieser Ausgestaltung ist es möglich, nur diejenigen Maxima 30, 31, 32, 33 des Signals Uₑ zu erfassen, die oberhalb des positiven Schwellwerts Pₛ liegen.

Zu einem späteren Zeitpunkt tritt der nächste Schnittpunkt 40 auf, bei dem das Signal Uₐ kleiner als das Signal Uₑ ist. Daraufhin wird ein Abtastvorgang mittels des Abtast/Halte-Signals A/H2 veranlaßt. Zu einem späteren Zeitpunkt tritt ein weiterer Schnittpunkt 41 zwischen den Signalen Uₐ, Uₑ auf, bei dem das Signal Uₐ größer als das Signal Uₑ ist. Daraufhin wird wieder ein Haltevorgang mittels des Abtast/Halte-Signals A/H2 veranlaßt. Das Signal Uₐ weist danach das Maximum 37 auf, das dem Maximum 33 des Signals Uₑ entspricht. Die Auslösung des Haltevorgangs kann in der bereits beschriebenen Weise in Abhängigkeit von dem Signal P ausgelöst werden. Das positive Maximum 33 tritt innerhalb der Abtastzeit T_{A/H} auf. Der Haltezustand der zweiten Abtast/Halte-Schaltung 16 wird mit Auftreten der negativen Flanke des Abtast/Halte-Signals A/H1 veranlassen, die den Zeitpunkt angibt, bei dem die erste Abtast/Halte-Schaltung 17 das zuletzt vorliegende Signal Uₐ gespeichert hat. Danach steht das in der Abtast/Halte-Schaltung 17 gespeicherte positive Maximum 33 des zu erfassenden Signals Uₑ zur weiteren Signalverarbeitung zur Verfügung.

Nach dem Einleiten des Abtastvorgangs mit der negativen Flanke des Signals A/H1 nimmt das Signal Uₐ wieder den Wert des Eingangssignals Uₑ an. Während der Berührung 42 ist der Pegel des Signals MAX für einen bestimmten Zeitbereich 45 nicht eindeutig definiert. Der Bereich 45 ist mit der Maßnahme vermeidbar, daß dem dritten Vergleichsmittel 13, das beispielsweise als Komparatorschaltung realisiert ist, ein Hystereseverhalten gegeben wird. Wesentlich ist, daß das Abtast/Halte-Signal A/H2 durch die Pegeländerung des Signals MAX im Bereich 45 keinen weiteren Haltevorgang auslöst, da es bereits durch die zuvor aufgetretene negative Flanke des Abtast/Halte-Signals A/H1 auf den Abtastpegel zurückgesetzt wurde.

Beim nächsten Schnittpunkt 43 der Signale Uₑ, Uₐ tritt wieder das Signal MAX auf, welches über das Abtast/Halte-Signal A/H2 einen Haltevorgang der zweiten Abtast/Halte-Schaltung 16 auslöst. Das lokale Maximum 31 des Signals U_{E} ist das einzige Maximum, das im nächsten Abtastintervall T_{A/H} auftritt. Das lokale Maximum 31 ist damit das Maximum 31, das mittels des Signals Uₐ als positives Maximum 36 gespeichert ist. Nach dem Auftreten der negativen Flanke des Abtast/Halte-Signals A/H1 wird, mit dem Beenden des Haltevorgangs in der zweiten Abtast/Halte-Schaltung 16, gleichzeitig deren Ausgangssignal Uₐ in der ersten Abtast/Halte-Schaltung 17 gespeichert.

Inzwischen hat das zu erfassende Signal Uₑ den gegebenenfalls vorgesehenen negativen Schwellwert N_{S} unterschritten. Dieser Zustand wird durch das Auftreten des Signals N angezeigt.

Beim nächsten Schnittpunkt 44 der Signale Uₑ, Uₐ ändert das Signal MAX wieder seinen Pegel. Daraufhin wird wieder ein Haltevorgang der zweiten Abtast/Halte-Schaltung 16 mittels des Abtast/Halte-Signals A/H2 ausgelöst. Das Auslösen des Haltevorgangs wird in vorteilhafter Weise abhängig gemacht vom Auftreten des Signals N, das anzeigt, daß das zu erfassende Signal Uₑ kleiner als der negative Schwellwert N_{S} ist. Damit wird das negative Maximum 34 des zu erfassenden Signals Uₑ als negatives Maximum 38 in der zweiten Abtast/Halte-Schaltung 16 gespeichert. Das Auftreten eines weiteren lokalen positiven Maximums 32 des Signals Uₑ hat keine Auswirkungen auf die weitere Signalverarbeitung, weil das negative Maximum 38 gespeichert ist und vorrangig weiterverarbeitet wird.

Ein Haltevorgang mittels des Abtast/Halte-Signals A/H2 der zweiten Abtast/Halte-Schaltung 16 wird daher immer dann ausgelöst, wenn entweder das Signal Uₐ größer als das Signal Uₑ und gegebenenfalls das Signal Uₑ größer als der positive Schwellwert P_{S} oder wenn das Signal Uₐ kleiner als das Signal Uₑ und das Signal Uₑ kleiner als der negative Schwellwert N_{S} ist. Ein Abtastvorgang tritt dagegen auf, wenn entweder gegebenenfalls das Signal Uₑ kleiner als der positive Schwellwert P_{S} und das Signal Uₑ größer als der negative Schwellwert N_{S} oder wenn das Signal Uₐ kleiner als das Signal Uₑ und das Signal Uₑ größer als der positive Schwellwert P_{S} oder wenn das Signal Uₐ größer als das Signal Uₑ und das Signal Uₑ kleiner als der negative Schwellwert N_{S} ist oder wenn eine fallende Flanke des Abtast/Halte-Signals A/H1 auftritt.

Die Verzögerungszeit der Verzögerungsmittel 10 ist derart zu bemessen, daß Verzögerungszeit plus der Zeit, die die zweite Abtast/Halte-Schaltung 16 zum Speichern des Ausgangssignals 15 der Signalverzögerungsmittel 10 benötigt, gleich der Zeiten ist, die zum einen als Verzögerungszeit der dritten Vergleichsmittel 13 auftritt und zum anderen als Signalverarbeitungszeit der signalverarbeitenden Anordnung 14 bis zum Auftreten des Abtast/Halte-Signals A/H2 benötigt wird. Die Signalverarbeitungsgeschwindigkeit der signalverarbeitenden Anordnung 14 ist im wesentlichen durch die Frequenz des Taktsignals 25 festgelegt. Die Frequenz des Taktsignals 25 liegt daher erheblich höher als die Frequenz des Abtast/Halte-Signals A/H1, das nach dem Frequenzteiler 23 auftritt.

Die erfindungsgemäße Vorrichtung eignet sich insbesondere zur Weiterverarbeitung des Signals Uₐ in dem Analog/Digital-Wandler 22. Die erfindungsgemäße Vorrichtung mit dieser Ausgestaltung eignet sich insbesondere zur Verwendung in einem Digital-Speicheroszilloskop. Die erfindungsgemäße Vorrichtung ermöglicht das Erfassen von Maxima 31, 33, 34 des Signals Uₑ, obwohl der verwendete Analog/Digital-Wandler 22 eine niedrigere Abtastrate entsprechend der Zeit T_{A/H} aufweist, als sie zur Verarbeitung von derartigen Maxima 31, 33, 34 erforderlich wäre.

Eine bevorzugte Verwendung ist gegeben bei der Auswertung von Zündsignalen, die bei der Zündung von fremdgezündeten Brennkraftmaschinen auftreten. Derartige Signals weisen kurzzeitige Signalanteile auf, deren Spektrum erheblich höhere Frequenzanteile aufweist als das der übrigen Signalanteile. Insbesondere der Einsatz wenigstens eines Schwellwertes P_{S}, N_{S} ermöglicht die Auswertung wesentlicher Teile des Zündsignals. Das in Figur 2 gezeigte Signal Uₑ entspricht beispielsweise einem derartigen Zündsignal, bei dem hier beispielsweise zunächst das lokale Maximum 30 vor der Zündnadel auftritt, die dem positiven Maximum 33 entspricht. Danach folgt die Brennlinie gefolgt vom Funkenabriß, der zu einem weiteren Schwingvorgang mit dem positiven Maximum 31 und dem anschließenden negativen Maximum 34 führen kann.

Die erfindungsgemäße Vorrichtung ermöglicht die Erfassung der Maxima 31, 33, 34 des Zündsignals mit kostengünstigen Mitteln. Insbesondere die Signalverzögerungsmittel 10 sowie die Vergleichsmittel 11, 12 sind in analoger Schaltungstechnik preiswert bis zu hohen Frequenzen realisierbar. Eine digitale Signalverarbeitung braucht an dieser Stelle noch nicht vorgesehen zu sein. Die signalverarbeitende Anordnung 14 kann als diskrete digitale Schaltung, beispielsweise innerhalb eines Programmable-Logic-Array-Bausteins, oder - sofern die Verarbeitungsgeschwindigkeit ausreicht - auch in Form von Software in einem Mikrocomputersystem realisiert sein.

## Patentansprüche

1. Vorrichtung zum Erfassen eines Signals (Uₑ), mit einer ersten Abtast/Halte-Schaltung (17) und einem Mittel (10, 13, 16) zum Detektieren und Speichern eines innerhalb einer Abtastzeit (T_{A/H}) liegenden Maximums (31, 33, 34) des Signals (Uₑ), das eine zweite Abtast/Halte-Schaltung (16), deren Ausgang mit dem Eingang der ersten Abtast/Halte-Schaltung (17) verbunden ist, Signalverzögerungsmittel (10) und erste Vergleichsmittel (13) mit einem ersten Eingang, der mit dem Signal (Uₑ) verbunden ist, und einem zweiten Eingang, der mit dem Ausgang der zweiten Abtast/Halte-Schaltung (16) verbunden ist, aufweist, dadurch gekennzeichnet, daß die Signalverzögerungsmittel (10) der zweiten Abtast/Halte-Schaltung (16) vorgeschaltet sind, und daß zweite Vergleichsmittel (11, 12) vorgesehen sind, deren Eingang mit dem Eingang des Signalverzögerungsmittels (10) und deren Ausgang mit der zweiten Abtast/Halte-Schaltung (16) derart verbunden sind, daß das Speichern des Maximums nur möglich ist, solange das Signal (Uₑ) größer als eine vorgegebene Schwelle (P_{S}, N_{S}) ist.

2. Vorrichtung nach Anspruch 1, dadurch gekennzeichnet, daß die Signalverzögerungsmittel (10) ein Allpaß sind.

3. Verwendung einer Vorrichtung nach Anspruch 1 in einem digitalen Speicheroszilloskop.

4. Verwendung einer Vorrichtung nach Anspruch 1 zum Erfassen von Zündsignalen als Signal (Uₑ), die bei der Zündung von fremdgezündeten Brennkraftmaschinen auftreten.

## Claims

1. Device for detecting a signal (Uₑ), having a first sample/hold circuit (17) and a means (10, 13, 16) for detecting and storing a maximum (31, 33, 34), lying within a sampling time (T_{A/H}), of the signal (Uₑ), which means has a second sample/hold circuit (16), whose output is connected to the input of the first sample/hold circuit (17), signal delay means (10) and first comparison means (13) having a first input, which is connected to the signal (Uₑ), and a second input, which is connected to the output of the second sample/hold circuit (16), characterized in that the signal delay means (10) are connected upstream of the second sample/hold circuit (16), and in that second comparison means (11, 12) are provided, whose input is connected to the input of the signal delay means (10) and whose output is connected to the second sample/hold circuit (16) in such a way that the storage of the maximum is only possible as long as the signal (Uₑ) is greater than a predetermined threshold (P_{S}, N_{S}).

2. Device according to Claim 1, characterized in that the signal delay means (10) are an all-pass network.

3. Use of a device according to Claim 1 in a digital storage oscilloscope.

4. Use of a device according to Claim 1 for detecting ignition signals as the signal (Uₑ), which occur during the ignition of spark-ignition internal combustion engines.

## Revendications

1. Dispositif de détection d'un signal (Uₑ) avec un premier circuit de détection/maintien (17) et un moyen (10, 13, 16) pour détecter et mettre en mémoire un maximum (31, 33, 34) compris dans une durée de détection (T_{A/H}) pour le signal (Uₑ), qui est appliqué à l'entrée du second circuit de détection/maintien (17), des moyens de temporisation de signal (10) et un premier comparateur (13) avec une première entrée reliée au signal (Uₑ) et une seconde entrée reliée à la sortie du second circuit de détection et de traitement (16),
caractérisé par
des moyens de temporisation (10) prévus en amont du second circuit de détection et de maintien (16) et un second moyen de comparaison (12) dont l'entrée est reliée à la sortie du moyen de temporisation de signal (10) et sa sortie est reliée au second circuit de détection et de maintien (16) pour que la mise en mémoire du maximum ne soit pas possible aussi longtemps que le signal (Uₑ) est supérieur à un seuil prédéterminé (P_{S}, Nₛ).

2. Dispositif selon la revendication 1,
caractérisé en ce que
les moyens de temporisation de signal (10) sont constitués par un filtre passe-tout.

3. Application d'un dispositif selon la revendication 1 à un oscilloscope numérique à mémoire.

4. Application d'un dispositif selon la revendication 1 pour détecter les signaux d'allumage comme signaux (Uₑ) produits lors de l'allumage de moteurs à combustion interne à allumage commandé.
